Europäisches Patentamt

European Patent Office

Office européen des brevets

(19)

(11) Publication number: **0 000 557**
**B1**

(12) **EUROPEAN PATENT SPECIFICATION**

(45) Date of publication of patent specification: **30.12.81**

(51) Int. Cl.³: **H 01 S 3/19, H 01 S 3/06**

(21) Application number: **78100461.9**

(22) Date of filing: **20.07.78**

(54) Semiconductor laser device.

(30) Priority: **01.08.77 JP 91368/77**
**24.03.78 JP 36912/78 U**

(43) Date of publication of application:
**07.02.79 Bulletin 79/3**

(45) Publication of the grant of the European patent:
**30.12.81 Bulletin 81/52**

(84) Designated Contracting States:
**DE FR GB NL**

(56) References cited:
**FR - A - 2 348 589**
**US - A - 3 978 428**
**US - A - 4 023 993**

**APPLIED PHYSICS LETTERS; vol. 30, no. 10, 15 May 1977, New York USA**
**W. T. TSANG et al "Lateral current confinement by reverse-biased junctions in GaAs-Al$_x$Ga$_{1-x}$AsDH lasers", pages 538—540.**

**IEEE JOURNAL OF QUANTUM ELECTRONICS, vol. QE 13, no. 4, April 1977 New York, USA**
**AMMON YARIV et al "Periodic structures for integrated optics", pages 233—253.**

(73) Proprietor: **Hitachi, Ltd.**
**5-1, Marunouchi 1-chome**
**Chiyoda-ku Tokyo 100 (JP)**

(72) Inventor: **Nakamura, Michiharu**
**2196-283, Hirai, Hinode-machi**
**Nishitama-gun**
**Tokyo (JP)**
Inventor: **Yamashita, Shigeo**
**1-48-18, Akatsuki-cho**
**Hachioji-shi Tokyo (JP)**
Inventor: **Kuroda, Takao**
**4-1-2, Hiyoshi-cho**
**Kokubunji-shi Tokyo (JP)**
Inventor: **Umeda, Junichi**
**612-10, Kamiichibukata-cho**
**Hachioji-shi Tokyo (JP)**

(74) Representative: **Schiff, Karl Ludwig et al,**
**Patentanwälte Schiff, v. Füner, Strehl, Schübel-Hopf, Ebbinghaus; Finck Mariahilfplatz 2-3**
**D-8000 München 90 (DE)**

Courier Press, Leamington Spa, England.

# 0 000 557

## Semiconductor laser device

This invention relates to a semiconductor laser device with a first semiconductor layer and with a second and a third semiconductor layer which sandwich said first semiconductor layer therebetween, which are greater in the band gap and lower in the refractive index than said first semiconductor layer and which have conductivity types opposite to each other, with a fourth semiconductor layer rendering the effective complex refractive index for the laser beam discontinuous in a direction perpendicular to the travelling direction of the laser beam, and with periodic corrugations formed in at least one interface of the semiconductor layers constituting an optical wave guide of said semiconductor laser device in a manner to intersect orthogonally to said travelling direction of the laser beam.

Semiconductor laser devices have many merits, such as small size, operation at high efficiency, and capability of direct modulation by a drive current. They are therefore hopeful as light sources for optical communication, optical information processing, etc.

A distributed-feedback semiconductor laser device having the above features is known from U.S. patent specification 4 023 993. Such a distributed-feedback semiconductor laser achieves mode stabilization by exploiting the sharp oscillation mode selectivity which is produced by the light diffraction effect based on the corrugated surface.

Further distributed-feedback semiconductor laser devices have been reported in detail in "Applied Physics Letters", vol. 27, pages 403 to 405, October 1975, by M. Nakamura et al., and in "IEEE Journal of Quantum Electronics", vol. QE-12, pages 597 to 603, October 1976, by K. Aiki et al.

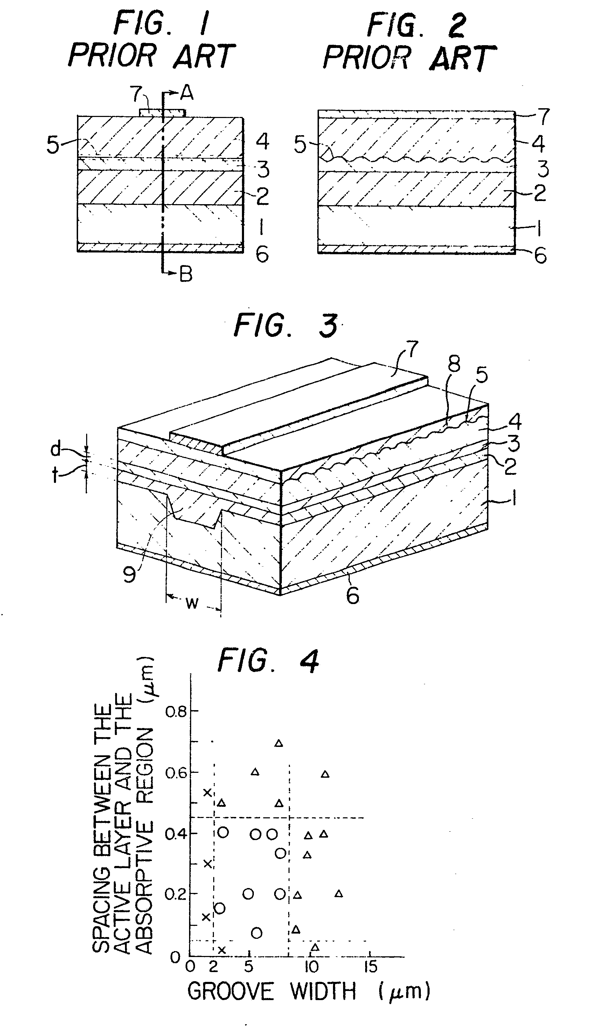

Figs. 1 and 2 of the accompanying drawing show an example of the distributed-feedback semiconductor laser device. Fig. 1 is a sectional view taken orthogonally to the travelling direction of light, while Fig. 2 is a sectional view taken along the travelling direction of light. Here, numeral 1 designates an n-GaAs substrate, numeral 2 an n-$Ga_{1-x}Al_xAs$ layer ($x \simeq 0.3$), numeral 3 a GaAs active layer, numeral 4 a p-$Ga_{1-x}Al_xAs$ layer, and numeral 5 periodic corrugations which are provided at the boundary between the active layer 3 and the semiconductor layer 4. Numerals 6 and 7 indicate ohmic electrodes. The layers 2, 3 and 4 constitute an optical waveguide. Light given forth in active layer 3 is guided centering around the active layer 3, and is subjected to the Bragg reflection of 180° by the periodic corrugations 5 formed at the boundary between the layers 3 and 4.

The distributed-feedback semiconductor laser device oscillates at a single longitudinal mode and exhibits a spectral width of 0.05 mm (0.5 Å) or less, so that it is excellent in monochromaticity. In addition, the temperature-dependency of the oscillation wavelength is low.

Even in the distributed-feedback semiconductor laser device controlled to the single longitudinal mode, however, the generation of excess optical noise especially for a modulated signal due to transverse mode instability is not avoided yet.

This invention has for its object to provide a novel semiconductor laser device in which a longitudinal and transverse mode is stabilized singly and in which any excess optical noise component for a modulated signal is not generated by mode competition.

In order to accomplish this object, the semiconductor laser device of the type initially referred to is characterized, in accordance with the present invention, in that said second and/or said third semiconductor layer have a protuberant region or are bordered on their side remote from said first semiconductor layer by a fifth semiconductor layer with a protuberant region, that said protuberant region having a width able to stabilize a transverse mode of the laser oscillation extends in said travelling direction of the laser beam and has the shape of a stripe on its surface side remote from said first semiconductor layer, that said fourth semiconductor layer has portions on both sides of said protuberant region, and that said periodic corrugations are formed to include at least a region overlying said protuberant region.

Advantageous developments of the invention are called for in claims 2 to 11.

The features of the characterizing part of claim 2 and a semiconductor laser which consists of five semiconductor layers made of $Ga_{1-x}Al_xAs$ and of a GaAs substrate are known from "IEEE Journal of Quantum Electronics", vol. QE-13, No. 4, April 1977, pages 233 to 253.

From "Applied Physics Letters", vol. 30, No. 10, May 1977, pages 538 to 540, a semiconductor laser is known, which is equipped with a first semiconductor layer and with a second and a third semiconductor layer which sandwich the first semiconductor layer therebetween, said second semiconductor layer having a protuberant region on both sides of which a semiconductor layer is disposed. The protuberant region extends in the travelling direction of the laser beam and has the shape of a stripe on its surface side remote from the first semiconductor layer. In these known devices, the protuberant region is used to confine the current through the active layer.

From U.S. patent specification 3,978,428, a semiconductor laser device is known, which is equipped with a first semiconductor layer and with a second and third semiconductor layer which sandwich said first semiconductor layer therebetween, with a semiconductor layer rendering the effective complex refractive index for the laser beam discontinuous in a direction perpendicular to the travelling direction of the laser beam, and with a substrate having an elongated groove extending in the travelling direction of the laser beam through a pump current confining layer, a central portion of the

2

first semiconductor layer being bowl-shaped. This structure is used to adapt the cross section of the emitted laser beam to round lenses.

Preferred embodiments of the invention will now be described with reference to the drawings, in which:

Figs. 1 and 2, which have been referred to above, are sectional views of a distributed-feedback semiconductor laser device of a prior art structure, which are respectively taken perpendicularly to, and along, the travelling direction of light;

Fig. 3 is a perspective view of a semiconductor laser device according to this invention;

Fig. 4 is a graph showing the influence of the groove width of the protuberant region and the distance from the active layer to a light absorptive region on the laser oscillation.

Figs. 5 to 8 are diagrams showing the states of generation of excess optical noise ascribable to mode competition in various semiconductor laser devices;

Figs. 9 to 10 are sectional views of a device of another embodiment of this invention, which are respectively taken perpendicularly to, and along, the travelling direction of light;

Fig. 11 is a graph showing the light output versus current characteristics of one embodiment of the present invention;

Fig. 12 is a graph showing far-field intensity distributions in the junction plane;

Fig. 13 shows the lasing spectra of one embodiment of the present invention operating under d.c. bias;

Fig. 14 shows the pulse response of one embodiment of the present invention at different excitation levels; and

Figs. 15 and 16 are sectional views of devices of further embodiments of this invention as taken perpendicularly to the travelling direction of light.

This invention will be described in detail with reference to a typical example. Fig. 3 is a perspective view of the typical example of this invention.

On an n-GaAs substrate 1 as the fourth semiconductor layer formed with a groove 9; an n-Ga$_{1-x}$Al$_x$As (x $\simeq$ 0.3) layer 2 as the second semiconductor layer, a GaAs active layer 3 as the first semiconductor layer and a p-Ga$_{1-y}$Al$_y$As (y $\simeq$ 0.3) layer 4 as the third semiconductor layer are successively formed by the well-known liquid-phase epitaxy. The upper surface of the p-Ga$_{1-y}$Al$_y$As layer 4 is formed with periodic corrugations 8. Numerals 6 and 7 designate ohmic electrodes.

In the present structure, light generated in the active layer 3 is confined in the vertical direction around the active layer by the double-heterostructure. Part of the light evanesces to the GaAlAs layers 2 and 4 on both the sides. The light having evanesced to the N-Ga$_{1-x}$Al$_x$As layer 2 reaches the GaAs substrate 1 in regions on both the sides of the groove 9 because the n-Ga$_{1-x}$Al$_x$As layer 2 in these regions is thin. In consequence, the complex refractive-index for the light becomes different between the region corresponding to the groove 9 and the regions corresponding to both the sides of the groove 9. For this reason, any higher-order mode oscillation spreading to outside of the groove and the deviation of the oscillation region are suppressed, and the effect that the light is stably confined only to the region of the groove 9 in the lateral direction is produced.

On the other hand, the periodic corrugations 8 are provided at the interface between the semiconductor layers 4 and 5. Therefore, the effective complex refractive-index n$_e$ for the light given forth in the active layer 3 varies periodically in the travelling direction of the light. n$_e$ can approximately be expressed as follows:

$$n_e = n_o + \sum_{l=1}^{\infty} \Delta n^{(l)} \cos \left( \frac{2\pi}{\Lambda} lz \right);$$

where l = 1, 2, 3, . . .; n$_o$ and $\Delta n^{(l)}$ are constants.

The travelling direction of the light is taken in the z-direction.

Therefore, the laser light is diffracted, and

$$\lambda = 2 \, n_g \, \Lambda/l;$$

where $\lambda$: wavelength of the light, n$_g$: effective refractive index of waveguide, A: period of the corrugations and l: order of the diffraction. By fulfilling the condition, the light is subjected to the Bragg reflection at 180°. Accordingly, the light is confined in the waveguide, and the laser oscillation becomes possible.

In the above, the fundamental operation of the semiconductor laser of this invention has been explained. In order to realize the semiconductor laser intended by this invention wherein a longitudinal and transverse mode is stabilized, especially any excess optical noise component for a modulated signal is not generated by mode competition, a construction as described below is required.

The width of the stripe-shaped light non-absorptive protuberant region corresponding substantially to the radiation region is made 2 $\mu$m to 8 $\mu$m. With widths below 2 $\mu$m, especially the threshold current density (the lowest current density necessary for attaining the laser oscillation) increases rapidly. With widths above 8 $\mu$m, especially the instability of the transverse mode increases.

As to the quantity of evanescence of the light to the regions which exist on both sides of the light non-absorptive protuberant region and which make the complex refractive index for the laser beam discontinuous, at least $3 \times 10^{-2}$% of the whole quantity of the light, preferably $5 \times 10^{-2}$% to $5 \times 10^{-1}$ % of the same is appropriate. Thus, the absolute value of the index different $|\Delta n|$ in both the regions is preferably made $10^{-3}$ to $10^{-2}$. When the quantity of evanescence of the light is too small, especially the effect of confinement in the lateral direction is unsatisfactory. On the other hand, when the quantity of evanescence of the light is too large, the quantity of absorption of the light increases, and the increase of the threshold current density is incurred. Therefore, the thickness $d$ of the active layer 3 and the thickness $t$ of the n-Ga$_{1-x}$Al$_x$As layer 2 need to be selected. The thickness of the active layer is ordinarily set at 0.05 $\mu$m to 0.15$\mu$m. When the thickness $d$ of the active layer is 0.1 $\mu$m, it is favorable to make the thickness $t$ at most 0.5 $\mu$m; when the thickness $d$ is 0.15 $\mu$m, it is favorable to make the thickness $t$ at most 0.2 $\mu$m; when the thickness $d$ is 0.05 $\mu$m, it is favorable to make the thickness $t$ at most 0.7 $\mu$m. Regarding any intervening thickness of the active layer, the thickness of the semiconductor layer 2 may be set by the interpolation with the aforecited values.

On the other hand, the distance $c$ between the active layer 3 and the periodic corrugations 8 which are provided at the interface between the semiconductor layers 4 and 5 is made at most 1 $\mu$m, preferably at most 0.5 $\mu$m, and at least 0.03 $\mu$m. When the distance $c$ is below 0.03 $\mu$m, the carrier confinement effect owing to the p-Ga$_{1-y}$Al$_y$As layer 4 becomes insufficient, and an increase of the threshold current density is incurred. When the distance $c$ is above 1 $\mu$m, the degree to which the radiation in the active layer senses the periodic corrugations decreases abruptly, so that the laser oscillation of the distributed feedback type does not take place.

The depth L of the corrugations is desirably selected in a range of 0.01 $\mu$m to 0.5 $\mu$m. When the depth L is less than 0.01 $\mu$m, the Bragg reflection of the light owing to the periodic corrugation structure becomes insufficient, and the laser oscillation of the distributed feedback type becomes difficult. Even when the depth L is selected to be greater than 0.5 $\mu$m, the light is distributed in a limited range centering around the active layer, so that the intensity of the Bragg reflection becomes substantially constant and the effect based on the increase of the depth L diminishes.

In the above, the fundamental concept of this invention has been described in connection with the typical example of this invention illustrated in Fig. 3.

Various modifications can be contrived as to how the light non-absorptive protuberant region in the vicinity of the active layer and the regions situated on both the sides of the non-absorptive protuberant region for making the complex refractive index for the laser beam discontinuous are provided at which interface among the stacked semiconductor layers the periodic corrugation is provided at, etc. By way of example, the semiconductor layer corresponding to the semiconductor substrate 1 in Fig. 3 may consist of a plurality of layers. It is also allowed to form a separate semiconductor layer on the semiconductor substrate and to provide a recess in the separate semiconductor layer, the recess being used as the groove 9 in Fig. 3. The purpose can be achieved even when a discontinuity in only the refractive index (corresponding to the real part of the complex refractive index) is produced. In any case, however, the technical items previously described may be conformed with.

Although, in examples to be stated later, a GaAsGaAlAs conductor will be referred to as a semiconductive material, it is obvious that the present invention concerns the property of a laser resonator including an optical waveguide and that it is independent of materials. This invention is accordingly applicable, not only to semiconductor lasers employing the above-mentioned semiconductor, but also to semiconductor lasers employing e.g. a ternary system compound semiconductor such as GaInP, GaAsP and GaAlSb and a quaternary system compound semiconductor such as GaInAsP and GaAlAsSb.

Hereunder, this invention will be described more in detail in connection with examples.

Example 1

Description will be made with reference to Fig. 3. In an n-GaAs substrate 1 (Te-doped, electron concentration n 1 $\times$ 10$^{18}$/cm$^3$) having the (100) face as its surface, a groove 9 having a depth of 1.5 $\mu$m and a desired width in the range of 2 $\mu$m to 8 $\mu$m was formed in the (011) orientation. In the formation, the conventional photolithography may be employed. As an etching mask, photoresist was directly used. The chemical etching was conducted at 20°C for about 140 seconds with a mixed solution which contained phosphoric acid, hydrogen peroxide solution and ethylene glycol at 1:1:3.

On the resultant substrate 1, an n-Ga$_{1-x}$Al$_x$As layer 2 as the second semiconductor layer (x $\simeq$ 0.3, electron concentration n $\simeq$ 5 $\times$ 10$^{17}$ cm$^{-3}$) being 0.3 $\mu$m thick, a GaAs active layer 3 as the first semiconductor layer being 0.1 $\mu$m thick, and a p-Ga$_{1-y}$Al$_y$As layer 4 as the third semiconductor layer (y $\simeq$ 0.3, hole concentration p $\simeq$ 5 $\times$ 10$^{17}$ cm$^{-3}$) being 0.2 $\mu$m thick, were continuously grown by the conventional liquid-phase epitaxy employing a slide boat.

As regards the GaAlAs system material, it is common to employ Ga$_{1-z}$Al$_z$As (0 $\leqq$ z $\leqq$ 0.3) for the first semiconductor layer, Ga$_{1-x}$Al$_x$As (0.1 $\leqq$ x $\leqq$ 0.9) for the second semiconductor layer and Ga$_{1-y}$Al$_y$As (0.1 $\leqq$ y $\leqq$ 0.9) for the third semiconductor layer, where x, y, > z; r > z; and y $\neq$ r.

Subsequently, corrugations 8 having a period of 370 nm (3 700 Å) and a depth of 150 nm

(1 500 Å) were formed in the surface of the p-$Ga_{1-y}Al_yAs$ layer 4. In forming the corrugations, holographic photolithography employing a laser beam and chemical etching were used. More specifically, a film of the positive type photoresist as was 80 nm (800 Å) thick was formed on the surface of the semiconductor layer 4. Subsequently, using an Ar laser at a wavelength of 457.9 nm (4 579 Å), an interference fringe was formed on the photoresist. After completing exposure, development was carried out for about 1 min with a mixed solution consisting of a developer and water at 1:1. In this way, a diffraction grating made of a photoresist was formed. The diffraction grating made of the photoresist was used as a mask, and a mixed solution consisting of phosphoric acid, a solution of hydrogen peroxide and ethylene glycol at 1:1:8 was used as an etchant. Periodic corrugations 8 having a depth of 0.15 $\mu$m were formed by the etching at 20°C for 80 seconds. This method is disclosed in Japanese Laid-Open Patent Application No. 111344/1976.

Subsequently, a p-$Ga_{1-y}Al_y$ As layer 5 as the sixth semiconductor layer ($y \simeq 0.1$ and in general, $0.05 \leqq y \leqq 0.09$; hole concentration p $\simeq 5 \times 10^{17}$ $cm^{-3}$) was formed to a thickness of 2.0 $\mu$m by employing the conventional liquid-phase epitaxial growth again. Zn was diffused into a desired region of the p-side surface of the specimen thus formed, whereupon Cr and Au were deposited by vacuum-evaporation so as to form an electrode. The substrate side was lapped down to about 150 $\mu$m, whereupon Au-Ge-Ni was brought into close contact to form an electrode. The laser length was made 300 $\mu$m.

As a result, when the groove width was 7 $\mu$m, the laser device oscillated at a threshold value of 110 mA and a wavelength of 830 nm (8 300 Å), and each of longitudinal and transverse modes was single and stable. Any excess optical noise otherwise generated by mode competition was not noted.

It is as previously stated that, in the present structure, the width W of the groove 9, the distance $t$ of the active region from the light absorptive region, the thickness $d$ of the active layer 3, the distance C between the active layer and the periodic corrugations, the depth L of the periodic corrugations, etc. have influence on the oscillation characteristics.

Fig. 4 shows the characteristics of semiconductor lasers employing various combinations between the width W of the groove 9 and the distance $t$ of the active region from the light absorptive region. While values of 0.05 $\mu$m to 0.15 $\mu$m are often employed as the thickness $d$ of the active layer 3, a value of 0.1 $\mu$m is given as a typical example. The depth L of the periodic corrugations is 150 $\mu$m (1 500 Å). Mark O indicates an example in which the laser device oscillated in a single mode longitudinally and transversely without any optical noise, mark $\Delta$ an example in which the laser device oscillated in a single longitudinal mode, but excess optical noise was generated by mode competition, and mark X an example in which the laser device did not reach the continuous oscillation on account of the increase of the threshold current density.

From the results, it is understood that the width W of the groove 9 capable of achieving the object is 2 $\mu$m to 8 $\mu$m. Regarding the distance $t$ of the active region from the light absorptive region, a value of 0.05 $\mu$m or less is the limit to which the layer can be stably fabricated in the actual process, while a value of 0.45 $\mu$m or greater falls in a region in which a desired light absorption was not attainable.

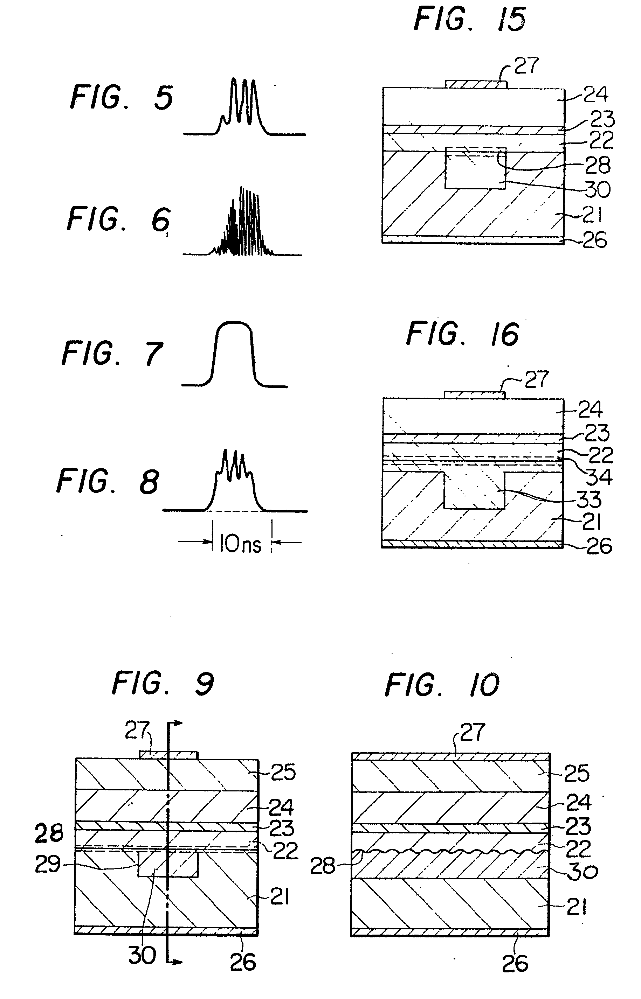

Figs. 5 to 8 illustrate the states of generation of excess optical noise attributed to mode competition. A square wave signal current having a pulse width of 8 ns, a pulse height of 160 mA (1.25 times a threshold value) and a recurrence frequency of 62.5 MHz was caused to flow through a semiconductor laser device having a threshold current of 130 mA, and the optical output of the semiconductor laser was observed. The optical output waveform is a result obtained by conversion into an electric signal with a photodiode of which the wavelength band was the oscillation wavelength $\pm$0.1 nm ( $\pm$1 Å) and the frequency band was 1 MHz to 0.8 GHz. Fig. 5 shows an example of the optical output waveform of the distributed-feedback semiconductor laser device exemplified in Fig. 1. Fig. 6 shows an example of the optical output waveform of a prior art buried heterostructure semiconductor laser device, Fig. 7 shows an example of the optical output waveform of the semiconductor laser device of this invention, and Fig. 8 shows an example of the optical output waveform of a semiconductor laser device which has a structure similar to that of this invention but whose stripe-shaped non-absorptive region is as broad as 12 $\mu$m. It is apprehended from the observation of the optical output waveforms that the semiconductor laser device of this invention is excellent.

The semiconductor laser device of the structure of this example is advantageous in that the deterioration is especially little and that the transverse mode is more easily stabilized. This originates in that the periodic corrugations can be formed after forming the active layer.

Example 2

Description will be made with reference to Figs. 9 and 10.

In the (011) orientation of an n-GaAs substrate 21 (Te-doped, electron concentration n $\simeq$ 1 $\times$ $10^{18}/cm^3$) having the (100) face as its surface, a groove 29 having a depth of about 1.5 $\mu$m and a desired width in a range of 2 $\mu$m to .8 $\mu$m was formed by the conventional photolithography and chemical etching. Photoresist was used for an etching mask. The chemical etching was conducted at 20°C for about 140 seconds with a mixed solution which consisted of phosphoric acid, hydrogen peroxide solution and ethylene glycol at 1:1:3.

On the resultant substrate 21, an n-$Ga_{1-s}Al_sAs$ layer 30 as the fifth semiconductor layer (s = 0.07, and in general, $0.1 \leqq s \leqq 0.9$; Sn-doped; electron concentration $n \simeq 5 \times 10^{17}/cm^3$) was grown to a thickness of 2.0 $\mu$m so as to fill up the groove flatly (to the extent that the thickness was about 0.5 $\mu$m outside the groove) by the conventional liquid-phase epitaxial growth employing a slide boat.

Subsequently, the surface of the grown layer was subjected to the chemical etching until the substrate 21 was exposed on both sides of the groove. The chemical etching was carried out at 20°C for about 70 seconds by the use of phosphoric acid, hydrogen peroxide solution and ethylene glycol at 1:1:3.

Subsequently, corrugations 28 having a period of 375 nm (3 750 Å) were formed in the direction orthogonal to the groove (in the (011) orientation) by the holographic photolithography employing a laser beam and the chemical etching. As a mask at this time, photoresist being about 80 nm (800 Å) thick was used. A mixed solution consisting of phosphoric acid, a solution of hydrogen peroxide and ethylene glycol at 1:1:8 was employed as at etchant, and the etching was conducted at 20°C for 80 seconds. As a result, the corrugations 28 being 0.15 $\mu$m deep were formed in the crystal surface.

Subsequently, an n-$Ga_{1-x}Al_xAs$ layer 22 ($x \simeq 0.3$; Sn-doped; electron concentration $n \simeq 5 \times 10^{17}$ $cm^{-3}$) being 0.4 $\mu$m thick, an n-$Ga_{1-z}Al_zAs$ active layer 23 ($z \simeq 0.05$; undoped; $n = 1 \times 10^{16}$ $cm^{-3}$) being 0.1 $\mu$m a p-$Ga_{1-x}Al_xAs$ layer 24 ($x \simeq 0.3$, Ge-doped; hole concentration $p = 10^{17}$ $cm^{-3}$) being 2 $\mu$m thick, and a p-GaAs layer 25 (Ge-doped; hole concentration $p = 5 \times 10^{17}$ $cm^{-3}$) being 1 $\mu$m thick were successively grown by employing the conventional liquid-phase epitaxial growth with the slide boat again.

Here, the Al contents of the respective layers must be so set that, with respect to light produced in the active layer 23, the substrate 21 becomes an absorptive region, while the stripe-shaped buried n-$Ga_{1-s}Al_sAs$ layer 30 becomes a non-absorptive region. The composition ratio between the n-$Ga_{1-s}Al_sAs$ layer 30 and the $Ga_{1-z}Al_zAs$ active layer 23 is made $z < s$, and it is desirable that (s—z) is approximately 0.01 or greater. On the other hand, the Al content $s$ of the n-$Ga_{1-s}Al_sAs$ layer 30 may, in principle, be made $0.01 \leqq s \leqq 0.9$. However, $s \leqq 0.1$ must be held in order that the crystal may be smoothly grown on this layer by the liquid-phase epitaxial growth generally employed. When $s > 0.1$, the normal liquid-phase growth becomes difficult in practice. As described above, (s—z) should desirably be approximately 0.01 or greater. Therefore, even in case where the active layer 23 is made a GaAs ($z = 0$ in $Ga_{1-z}Al_zAs$) layer it is necessary that $s \geqq 0.01$, and the lower limit value of $s$ becomes 0.01.

Zn was diffused into the p-side surface of this specimen by approximately 0.1 $\mu$m, whereupon Cr and Au were deposited by vacuum-evaporation so as to form an electrode 27. The substrate side was lapped down to approximately 150 $\mu$m, whereupon Au-Ge-Ni was evaporated to form an ohmic electrode 26.

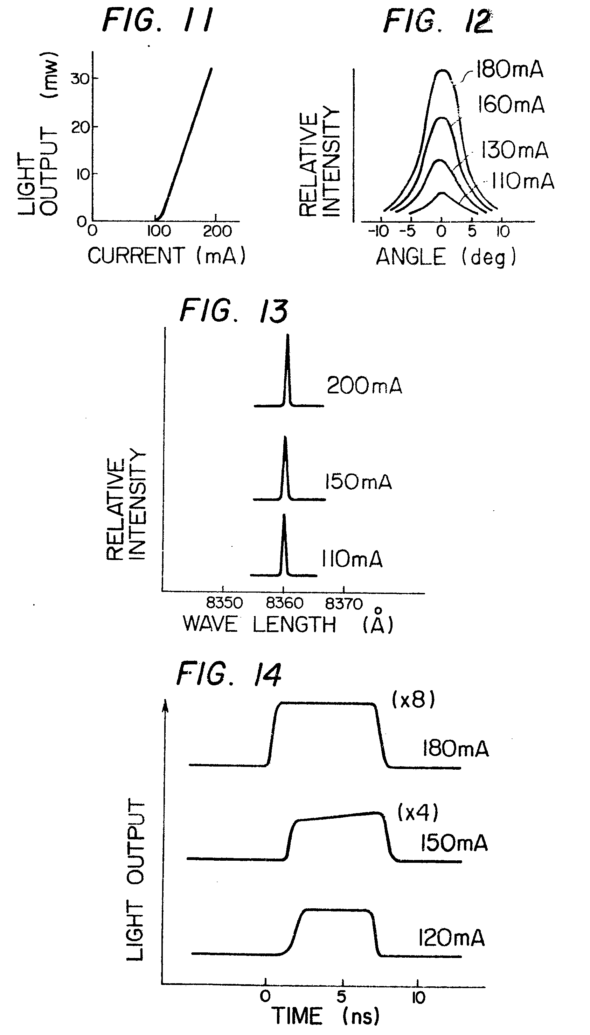

Fig. 11 is a graph showing the light output versus current characteristics of this embodiment, while Fig. 12 is a graph showing the far-field intensity distributions in the junction plane. The results were obtained in an example in which the semiconductor laser device had a length of 300 $\mu$m and a groove width of 7 $\mu$m. The threshold current value was 100 mA at room temperature, and the external differential quantum efficiency was about 35%. Fig. 11 corresponds to the light output versus current characteristics at this time. As apparent from the Figure, the laser oscillated in the fundamental transverse mode, and the transverse mode was stable up to above double the threshold value.

Fig. 13 shows the lasing spectra of the embodiment. The oscillation arose at a wavelength of 836 nm (8 360 Å), and even when the current value was increased double the threshold value, no change was noted. Fi. 14 shows the pulse responses at the time when current pulses having a width of 7 ns were impressed on the present laser device. Since the transverse mode was stabilized, the relaxation oscillation to become an optical noise as observed in the prior art distributed-feedback semiconductor laser was not noted.

## Example 3

Fig. 15 concerns another embodiment of this invention, and is a sectional view taken perpendicularly to the travelling direction of light within a laser. In the present element, corrugations 28 were formed on only the surface of the fifth semiconductor layer 30 grown in a groove. The other features were the same as in the case of Fig. 9. In this example, the feedback of light owing to the diffraction effect is selectively attained only in the upper part of the groove, and the lasing occurs concentratedly in this part. Therefore, the transverse mode is further stabilized. In case where the thickness of the active layer 23 was 0.1 $\mu$m and where the thickness of the second semiconductor layer 22 was 0.3 $\mu$m, the laser oscillated in the fundamental transverse mode up to triple the threshold value. Any excess optical noise for a modulated signal at the time of modulation as otherwise generated by mode competition was not noted.

## Example 4

Fig. 16 is a sectional view showing another embodiment of this invention. In the present laser device, an n-$Ga_{1-y}Al_yAs$ layer 33 as the fifth semiconductor layer, was grown on the whole surface of an n-GaAs substrate 21 in a manner to fill up the groove of the substrate, and corrugations 34 were formed thereon. The other features were the same as in Example 1. In this case, in order for light to evanesce to the substrate on the lateral outer sides, the sum of the thickness of the layer 33 and the layer 22 needed to be made 0.6 $\mu$m or less when the thickness of the active layer was 0.1 $\mu$m. By way of example, in case of a laser wherein the thickness of the fifth semiconductor layer 33 outside the groove was 0.2 $\mu$m, the thickness of the second semiconductor layer 22 was 0.2 $\mu$m, the thickness of the active layer was 0.1 $\mu$m, the groove width was 7 $\mu$m and the length was 300 $\mu$m, the threshold current value of the oscillation was 100 mA and each of the longitudinal and transverse modes was single and stable up to above double the threshold value.

As regards the arrangement of the periodic corrugations and the means for bestowing a difference on the complex refractive index, only examples in which such means exists on the substrate side have been explained above. This invention, however, is not restricted to such arrangement, but can adopt different constructions. For instance, a layer overlying an active layer is formed with periodic corrugations, whereupon a layer is formed which is provided with a protuberance corresponding substantially to a radiation portion. The protuberant layer is made a light non-absorptive layer. On this layer, a layer serving as a light absorptive layer is formed. With such a structure, the same effects as in the foregoing can be achieved.

## Claims

1. A semiconductor laser device with a first semiconductor layer (3; 23) and with a second (2; 22) and a third semiconductor layer (4; 24) which sandwich said first semiconductor layer therebetween, which are greater in the band gap and lower in the refractive index than said first semiconductor layer and which have conductivity types opposite to each other, with a fourth semiconductor layer (1; 21) rendering the effective complex refractive index for the laser beam discontinuous in a direction perpendicular to the travelling direction of the laser beam, and with periodic corrugations (8; 28; 34) formed in at least one interface of the semiconductor layers constituting an optical waveguide of said semiconductor laser device in a manner to intersect orthogonally to said travelling direction of the laser beam, characterized in that said second (2; 22) and/or said third semiconductor layer (4; 24) have a protuberant region (at 9 in Fig. 3) or are bordered on their side remote from said semiconductor layer by a fifth semiconductor layer (30; 33) with a protuberant region, that said protuberant region having a width able to stabilize a transverse mode of the laser oscillation extends in said travelling direction of the laser beam and has the shape of a stripe on its surface side remote from said first semiconductor layer, that said fourth semiconductor layer (1, 21) has portions on both sides of said protuberant region, and that said periodic corrugations (8; 28; 34) are formed to include at least a region overlying said protuberant region.

2. A semiconductor laser device according to claim 1, characterized in that the protuberant region is provided by said second (2) or by said third semiconductor layer (4), that said third or, respectively, said second semiconductor layer having no protuberant region is formed with said periodic corrugations (8) at its surface remote from said first semiconductor layer (3), and that a sixth semiconductor layer (5) is disposed on a surface of said periodic corrugations. (Fig. 3)

3. A semiconductor laser according to claim 1, characterized in that said periodic corrugations (28) are formed at the interface between said second (22) and/or said third semiconductor layer (24), respectively, and the bordering fifth semiconductor layer (30) as well as the bordering fourth semiconductor layer (21). (Figs. 9, 10; 15)

4. A semiconductor laser according to claim 1, characterized in that said fifth semiconductor layer (30) includes said protuberant region, and that said periodic corrugations (34) are formed at an interface between said second (22) and/or said third semiconductor layer (24) and the bordering fifth semiconductor layer. (Fig. 16)

5. A semiconductor laser device according to any of claims 1 to 4, characterized in that the absolute value of the difference between the effective complex refractive indices discontinuous for the laser beam is $10^{-3}$ to $10^{-2}$.

6. A semiconductor laser device according to any one of claims 1 to 5, characterized in that the width of the protuberant region (33) or said fifth semiconductor layer (30) is made 2 $\mu$m to 8 $\mu$m, and the distance from said first semiconductor layer (3; 23) to said periodic corrugations (8; 28; 34) is made 0.03 $\mu$m to 1 $\mu$m.

7. A semiconductor laser device according to any of claims 1 to 6, characterized in that the thickness of said first semiconductor layer (3; 23) is 0.05 $\mu$m to 0.15 $\mu$m.

8. A semiconductor laser device according to any of claims 1 to 7, characterized in that said fourth semiconductor layer (1; 21) is made of a semiconductor substrate which has a groove (9; 29) extending in said travelling direction of the laser beam and in the shape of said stripe.

9. A semiconductor laser device according to claim 8 as depending on claim 2, characterized in that said semiconductor substrate (1) is a GaAs substrate, said first semiconductor layer (3) is made of $Ga_{1-z}Al_zAs$ ($0 \leq z \leq 0.3$), said second semiconductor layer (2) is made of $Ga_{1-x}Al_xAs$ ($0.1 \leq x \leq 0.9$), said third semiconductor layer (4) is made of $Ga_{1-y}Al_yAs$ ($0.1 \leq y \leq 0.9$), and said sixth semiconductor layer (5) is made of $Ga_{1-p}Al_pAs$ ($0.05 < p < 0.9$) (where x, y > z; and y = p). (Fig. 3)

10. A semiconductor laser device according to claim 8 as depending on claim 3, characterized in that said semiconductor substrate (21) is a GaAs substrate, said first semiconductor layer (23) is made

7

of $Ga_{1-z}Al_zAs$ ($0 \leq z \leq 0.3$), said second semiconductor layer (22) is made of $Ga_{1-x}Al_xAs$ ($0.1 \leq x \leq 0.9$), said third semiconductor layer (24) is made of $Ga_{1-y}Al_yAs$ ($0.1 \leq y \leq 0.9$), and said fifth semiconductor layer (30) is made of $Ga_{1-s}Al_sAs$ $0.01 \leq s \leq 0.9$) (where x, y > z; s > z; and x ≒ s). (Figs. 9, 10; 15).

11. A semiconductor laser device according to claim 8 as depending on claim 4, characterized in that said semiconductor substrate (21) is a GaAs substrate, said first semiconductor layer (23) is made of $Ga_{1-z}Al_zAs$ ($0 \leq z \leq 0.3$), said second semiconductor layer (22) is made of $Ga_{1-x}Al_xAs$ ($0.1 \leq x \leq 0.9$), said third semiconductor layer (24) is made of $Ga_{1-y}Al_yAs$ ($0.1 \leq y \leq 0.9$), and said fifth semiconductor layer (33) is made of $Ga_{1-p}Al_pAs$ ($0.1 \leq p \leq 0.9$) (where x, y > z; $p$ > z; and x ≒ $p$). (Fig. 16).

## Revendications

1. Dispositif laser à semiconducteurs comportant une première couche semiconductrice (3, 23), une deuxième (2; 22) et une troisième (4; 24) couches semiconductrices entre lesquelles est prise en sandwich ladite première couch semiconductrice, lesdites deuxième et troisième couches semiconductrices étant à bande interdite plus haute et à indice de réfraction plus bas que ladite première couche semiconductrice et présentant des types de conductivité mutuellement opposés, une quatrième couche semiconductrice (1; 21) rendant discontinu l'indice de réfraction complexe effectif pour le faisceau laser dans une direction perpendiculaire à la direction de propagation du faisceau laser, et des ondulations périodiques (8; 28; 34) formées dans une interface au moins des couches semiconductrices constituant un guide d'ondes optique dudit dispositif laser à semiconducteurs de façon à couper orthogonalement ladite direction de propagation du faisceau laser, caractérisé en ce que ladite deuxième (2; 22) et/ou ladite troisième (4; 24) couches semiconductrices comportent une région protubérante (en 9 sur la figure 3) ou sont bordées sur leur côté éloigné de ladite première couche semiconductrice par une cinquième couche semiconductrice (30; 33) à région protubérante, en ce que ladite région protubérante, présentant une largeur propre à stabiliser un mode transversal de l'oscillation laser, s'étend dans ladite direction de propagation du faisceau laser et présente la forme d'une bande sur son flanc superficiel éloigné de ladite première couche semiconductrice (1; 21) comporte des portions de part et d'autre de ladite région protubérante, et en ce que lesdites ondulations périodiques (8; 28; 34) sont formées de façon à comprendre au moins une région coiffant ladite région protubérante.

2. Dispositif laser à semiconducteurs selon la revendication 1, caractérisé en ce que la région protubérante est fournie par ladite deuxième (2) ou par ladite troisième (4) couche semiconductrice, en ce que ladite troisième ou, respectivement ladite deuxième couche semiconductrice dépourvue de région protubérante est formée de façon à porter lesdites ondulations périodiques (8) à sa surface éloignée de ladite première couche semiconductrice (3), et en ce qu'une sixième couche semiconductrice (5) est disposée sur une surface desdites ondulations périodiques (figure 3).

3. Dispositif laser à semiconducteurs selon la revendication 1, caractérisé en ce que lesdites ondulations périodiques (28) sont formées à l'interface respective de ladite deuxième (22) et/ou de ladite troisième (24) couches semiconductrices avec la cinquième couche semiconductrice de bordure (30) ainsi qu'avec la quatrième couche semiconductrice de bordure (21). (Figures 9, 10, 15).

4. Dispositif laser à semiconducteurs selon la revendication 1, caractérisé en ce que ladite cinquième couche semiconductrice (30) comprend ladite région protubérante, et en ce que lesdites ondulations périodiques (34) sont formées à une interface entre ladite deuxième (22) et/ou ladite troisième (24) couches semiconductrices et la cinquième couche semiconductrice de bordure (Figure 16).

5. Dispositif laser à semiconducteurs selon l'une quelconque des revendications 1 à 4, caractérisé en ce que la valeur absolue de la différence entre les indices de réfraction complexes effectifs discontinus pour le faisceau laser est de $10^{-3}$ à $10^{-2}$.

6. Dispositif laser à semiconducteurs selon l'une quelconque des revendications 1 à 5, caractérisé en ce que la largeur de la région protubérante (33) ou de ladite cinquième couche semiconductrice (30) est de 2 $\mu$m à 8 $\mu$m, et en ce que la distance de ladite première couche semiconductrice (3; 23) auxdites ondulations périodiques (8; 28; 34) est de 0,03 $\mu$m à 1 $\mu$m.

7. Dispositif laser à semiconducteurs selon l'une quelconque des revendications 1 à 6, caractérisé en ce que l'épaisseur de ladite première couche semiconductrice (3; 23) est de 0,05 $\mu$m à 0,15 $\mu$m.

8. Dispositif laser à semiconducteurs selon l'une quelconque des revendications 1 à 7, caractérisé en ce que ladite quatrième couche semiconductrice (1; 21) est formée par un substrat semiconducteur qui comporte une gorge (9; 29) s'étendant dans ladite direction de propagation du faisceau laser et présentant la forme de ladite bande.

9. Dispositif laser à semiconducteurs selon la revendication 8, prise en rattachement à la revendication 2, caractérisé en ce que ledit substrat semiconducteur (1) est un substrat en GaAs, en ce que ladite première couche semiconductrice (3) est en $Ga_{1-z}Al_zAs$ ($0 \leq z \leq 0,3$), en ce que ladite deuxième couche semiconductrice (2) est en $Ga_{1-x}Al_xAs$ ($0,1 \leq x \leq 0,9$), en ce que ladite troisième couche semiconductrice (4) est en $Ga_{1-y}Al_yAs$ ($0,1 \leq y \leq 0,9$), et en ce que ladite sixième couche semiconductrice (5) est en $Ga_{1-p}Al_pAs$ ($0,05 < p < 0,9$) (avec x, y > z; et y $\neq$ $p$). (Figure 3).

10. Dispositif laser à semiconducteurs selon la revendication 8 prise en rattachement à la

8

**0 000 557**

revendication 3, caractérisé en ce que ledit substrat semiconducteur (21) est un substrat en GaAs, en ce que ladite première couche semiconductrice (23) est en $Ga_{1-z}Al_zAs$ ($0 \leq z \leq 0,3$), en ce que ladite deuxième couche semiconductrice (22) est en $Ga_{1-x}Al_xAs$ ($0,1 \leq x \leq 0,9$), en ce que ladite troisième couche semiconductrice (24) est en $Ga_{1-y}Al_yAs$ ($0,1 \leq y \leq 0,9$), et en ce que ladite cinquième couche semiconductrice (30) est en $Ga_{1-s}Al_sAs$ ($0,01 \leq s \leq 0,9$) (avec x, y > z; s > z; et x ≠ s). (Figures 9, 10; 15).

11. Dispositif laser à semiconducteurs selon la revendication 8 prise en rattachement à la revendication 4, caractérisé en ce que ledit substrat semiconducteur (21) est un substrat en GaAs, en ce que ladite première couche semiconductrice (23) est en $Ga_{1-z}Al_zAs$ ($0 \leq z \leq 0,3$), en ce que ladite deuxième couche semiconductrice (22) est en $Ga_{1-x}Al_xAs$ ($0,1 \leq x \leq 0,9$), en ce que ladite troisième couche semiconductrice (24) est en $Ga_{1-y}Al_yAs$ ($0,1 \leq y \leq 0,9$), et en ce que ladite cinquième couche semiconductrice (33) est en $Ga_{1-p}Al_pAs$ ($0,1 \leq p \leq 0,9$) (avec x, y > z; $p$ > z; et x ≠ $p$). (Figure 16).

**Patentansprüche**

1. Halbleiterlaser mit einer ersten (3; 23), einer zweiten (2; 22) und einer dritten (4; 24) Schicht aus Halbleitermaterial, wobei die zweite und die dritte Schicht die erste Schicht sandwichartig einschließen, einen größeren Bandabstand sowie einen geringeren Brechungsindex als die erste Schicht haben und jeweils einen zueinander entgegengesetzten Leitfähigkeitstyp aufweisen, mit einer vierten Schicht (1; 21) aus Halbleitermaterial, welche den effektiven komplexen Brechungsindex für den Laserstrahl diskontinuierlich macht in Bezug auf eine zur Ausbreitungsrichtung des Laserstrahls senkrechte Richtung, und mit periodischen Wellungen (8; 28; 34), die an wenigstens einer Grenzfläche der Schichten aus Halbleitermaterial ausgebildet sind und einen die Ausbreitungsrichtung des Laserstrahls orthogonal schneidenden optischen Wellenleiter des Halbleiterlasers bilden, dadurch gekennzeichnet, daß die zweite (2; 22) und/oder die dritte Schicht (4; 24) eine vorspringende Zone (bei 9 in Figur 3) aufweisen, oder an der von der ersten Schicht (1; 21) abgewandten Seite durch eine fünfte Schicht (30; 33) aus Halbleitermaterial mit einer vorspringenden Zone versehen sind, wobei die vorspringende Zone eine zur Stabilisierung des transversalen Schwingungsmodus der Laserschwingungen geeignete Weite hat, sich in Ausbreitungsrichtung des Laserstrahls erstreckt und an der von der ersten Schicht abgewandten Seite die Gestalt eines Bandes hat, daß die vierte Schicht (1; 21) Anteile zu beiden Seiten der vorspringenden Zone aufweist, und daß die periodischen Wellungen (8; 28; 34) wenigstens ein die vorspringende Zone bedeckendes Gebiet aufweisen.

2. Halbleiterlaser nach Anspruch 1, dadurch gekennzeichnet, daß die vorspringende Zone von der zweiten (2) oder von der dritten (4) Schicht aus Halbleitermaterial gegeben wird, daß die keine vorspringende Zone aufweisende dritte bzw. zweite Schicht aus Halbleitermaterial mit den periodischen Wellungen (8) an der von der ersten Halbleiterschicht (3) entfernt liegenden Oberfläche versehen ist, und daß eine sechste Schicht (5) aus Halbleitermaterial auf der Oberfläche der periodischen Wellungen angeordnet ist (Fig. 3).

3. Halbleiterlaser nach Anspruch 1, dadurch gekennzeichnet, daß die periodischen Wellungen (28) an der jeweiligen Grenzfläche der zweiten (22) und/oder der dritten (24) Schicht aus Halbleitermaterial mit der sie bedeckenden fünften Halbleiterschicht (30) oder auch der sie bedeckenden vierten Halbleiterschicht (21) ausgebildet sind (Fig. 9, 10; 14).

4. Halbleiterlaser nach Anspruch 1, dadurch gekennzeichnet, daß die fünfte Halbleiterschicht (30) die vorspringende Zone aufweist und daß die periodischen Wellungen (34) an einer Grenzfläche der zweiten (22) und/oder dritten (24) Halbleiterschicht mit der bedeckenden fünften Halbleiterschicht ausgebildet sind (Fig. 16).

5. Halbleiterlaser nach einem der Ansprüche 1 bis 4, dadurch gekennzeichnet, daß der Absolutwert der Differenz zwischen den effektiven komplexen, für den Laserstrahl diskontinuierlichen Brechungsindizes zwischen $10^{-3}$ und $10^{-2}$ beträgt.

6. Halbleiterlaser nach einem der Ansprüche 1 bis 5, dadurch gekennzeichnet, daß die Weite der vorspringenden Zone (33) oder der fünften Halbleiterschicht (30) zwischen 2 $\mu$m und 8 $\mu$m beträgt und daß der Abstand zwischen der ersten Halbleiterschicht (3; 23) und den periodischen Wellungen (8; 28; 34) zwischen 0,03 $\mu$m und 1 $\mu$m beträgt.

7. Halbleiterlaser nach einem der Ansprüche 1 bis 6, dadurch gekennzeichnet, daß die Dicke der ersten Halbleiterschicht (3; 23) zwischen 0,05 $\mu$m und 0,15 $\mu$m beträgt.

8. Halbleiterlaser nach einem der Ansprüche 1 bis 7, dadurch gekennzeichnet, daß die vierte Halbleiterschicht (1; 21) aus einem Halbleitersubstrat besteht, das eine Nut (9; 29) aufweist, welche sich in Ausbreitungsrichtung des Laserstrahls in der Gestalt eines Bandes erstreckt.

9. Halbleiterlaser nach Anspruch 2 und 8, dadurch gekennzeichnet, daß das Halbleitersubstrat (1) aus GaAs, die erste Halbleiterschicht (3) aus $Ga_{1-z}Al_zAs$ (mit $0 \leq z \leq 0,3$), die zweite Schicht (2) aus $Ga_{1-x}Al_xAs$ ($0,1 \leq x \leq 0,9$), die dritte Schicht (4) aus $Ga_{1-y}Al_yAs$ ($0,1 \leq y \leq 0,9$) und die sechste Schicht (5) aus $Ga_{1-p}Al_pAs$ ($0,05 < p < 0,9$) bestehen, wobei x, y > z und y ≠ $p$ ist (Fig. 3)

10. Halbleiterlaser nach Anspruch 3 und 8, dadurch gekennzeichnet, daß das Halbleitersubstrat (21) ein GaAs-Substrat ist, daß die erste Schicht (23) aus $Ga_{1-z}Al_zAs$ ($0 \leq z \leq 0,3$), die zweite Schicht (22) aus $Ga_{1-x}Al_xAs$ ($0,1 \leq x \leq 0,9$), die dritte Schicht (24) aus $Ga_{1-y}Al_yAs$ ($0,1 \leq y \leq 0,9$) und die fünfte

9

Schicht (30) aus $Ga_{1-s}Al_sAs$ ($0,01 \leqq s \leqq 0,9$) bestehen, wobei x, $\acute{y} > \acute{z}$, s > z und x $\neq$ s ist (Fig. 9, 10, 15).

11. Halbleiterlaser nach Anspruch 4 und 8, dadurch gekennzeichnet, daß das Halbleitersubstrat (21) aus GaAs, die erste Schicht (23) aus $Ga_{1-z}Al_zAs$ ($0 \leqq z \leqq 0,3$), die zweite Schicht (22) aus $Ga_{1-x}Al_xAs$ ($0,1 \leqq x \leqq 0,9$), die dritte Schicht (24) aus $Ga_{1-y}Al_yAs$ ($0,1 \leqq y \leqq 0,9$), und die fünfte Schicht (33) aus $Ga_{1-\gamma}Al_\gamma As$ ($0,1 \leqq \gamma \leqq 0,9$) besteht, wobei x, y > z, $\gamma > z$ und x $\neq \gamma$ (Fig. 16).

# FIG. 1
## PRIOR ART

# FIG. 2
## PRIOR ART

# FIG. 3

# FIG. 4

SPACING BETWEEN THE ACTIVE LAYER AND THE ABSORPTIVE REGION ($\mu$m)

GROOVE WIDTH ($\mu$m)

*FIG. 15*

*FIG. 5*

*FIG. 6*

*FIG. 7*

*FIG. 8*

|← 10ns →|

*FIG. 16*

*FIG. 9*

*FIG. 10*

2

0 000 557

**FIG. 11**

**FIG. 12**

**FIG. 13**

**FIG. 14**

3